(19) Europäisches Patentamt
European Patent Office
Office européen des brevets

(11) Publication number: **0 170 065**
**B1**

# (12) EUROPEAN PATENT SPECIFICATION

(45) Date of publication of patent specification: **20.12.89**

(51) Int. Cl.$^4$: **H 01 B 3/30,** C 08 L 81/06, C 08 L 79/08, C 08 L 67/02, C 08 L 81/02

(21) Application number: **85108029.1**

(22) Date of filing: **28.06.85**

## (54) Molded electrical device, molded circuit board substrate and molded chip carrier.

(30) Priority: **29.06.84 US 626147**

(43) Date of publication of application:
**05.02.86 Bulletin 86/06**

(45) Publication of the grant of the patent:
**20.12.89 Bulletin 89/51**

(84) Designated Contracting States:
**AT BE CH DE FR GB IT LI LU NL SE**

(56) References cited:
**EP-A-0 036 959**
**WO-A-84/03894**
**WO-A-84/04753**
**DE-A-2 852 750**
**FR-A-2 190 873**
**GB-A-2 054 623**
**US-A-3 729 527**

**CHEMICAL ABSTRACTS, vol. 90, no. 10, March 1979, page 37, no. 72919n, Columbus, Ohio, US; & JP - A - 78 129 248 (UNITIKA LTD.) 11-11-1978**

**CHEMICAL ABSTRACTS, vol. 84, no. 14, April 1979, page 33, no. 90983j, Columbus, Ohio, US; & JP - A - 75 146 648 (SUMITOMO CHEMICAL CO. LTD.) 25-11-1975**

(73) Proprietor: **AMOCO CORPORATION**
**200 East Randolph Drive P.O. Box 5910-A**
**Chicago Illinois 60680 (US)**

(72) Inventor: **Harris, James Elmer**
**211 Birchy View Drive**
**Piscataway New Jersey 08854 (US)**
Inventor: **Robeson, Lloyd Mahlon**
**R.d. No. 1, Box 244**
**Whitehouse Station New Jersey 08889 (US)**
Inventor: **Rimsa, Stephen Benedict**
**175 Welsh Road R.D. No.3**
**Lebanon New Jersey 08833 (US)**

(74) Representative: **Weinhold, Peter, Dr.**
**Patentanwälte Dr. V. Schmied-Kowarzik Dipl.-Ing. G. Dannenberg Dr. P. Weinhold Dr. D. Gudel Dipl.-Ing. S. Schubert Dr. P. Barz**
**Siegfriedstrasse 8**
**D-8000 München 40 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 170 065 B1

**Description**

This invention is directed to a molded electrical device comprising an electrically conductive pathway and an insulating material, the device being capable of interconnection with external circuitry, said insulating material comprising a blend of a particular amorphous thermoplastic polymer and a particular crystalline thermoplastic polymer. Also, this invention is directed to a molded circuit board substrate and a molded chip carrier.

EP—A—36 959 discloses molding compositions comprising a blend of a poly(arylether), a thermoplastic polyalkylene terephthalate, i.e. a polyester, and a mineral filler which compositions exhibit reduced splay in articles molded therefrom.

Furthermore, from JP—A—75/146648 (Chem. Abstr. 84: 90 983j (1976)) there are known blends of polyesters and poly(ethersulfones) which show improved processability.

It is well known that a wide variety of thermoplastic polymers have been used as substrates for electrical components, such as circuit board substrates. These substrates have been molded from, for example, polyphenyleneoxide, polyphenylenesulfide, polyimide and polyethersulfone. Additionally, the following documents disclose substrates made from thermoplastic polymers: US—A—4 520 067 describes a composition useful for making circuit board substrates and electrical connectors comprising a blend of certain proportions of a poly(ether sulfone) and a polysulfone.

EP—A—149 359 describes a select polyarylethersulfone which is useful for molding into circuit board substrates.

EP—A—111 327 describes a composition comprising a blend of a poly(arylether), a poly(etherimide) polymer, a fiber and a filler which is useful for making circuit board substrates and/or electrical connectors.

The polymers described above are used as circuit board substrates and in other electrical devices such as chip carriers. These materials are solderable by hand or wave soldering techniques. However, unlike hand and wave soldering, vapor phase soldering (VPS) constitutes a considerably more rigorous form of thermal exposure (as, for example, temperatures of about 216°C (420°F), and times of exposure of the substrate of from 30 seconds to in excess of 2 minutes). Unlike wave soldering which involves momentary exposure of the device to temperatures of 260°C (500°F), VPS requires that the electrical device be totally immersed in the soldering media. Thus, amorphous resin containing formulations that performed satisfactorily in hand and wave soldering exhibit deficiencies upon VPS exposure, i.e., they exhibit bubbles, blisters, distortion, and foaming. This is attributed to relatively high moisture absorption and low apparent modulus at the VPS processing temperature of the substrate made from amorphous resins.

Crystalline resin systems, on the other hand, have been found to exhibit low moisture absorption and a relatively high modulus at VPS processing temperatures. For example, mineral and/or glass-filled/reinforced poly(ethylene terephthalate) has demonstrated exceptional resistance to bubbling, blistering, and foaming in VPS exposure. However, while possibly suited for making small articles such as chip carriers, filled/reinforced poly(ethylene terephthalate) systems are unacceptable for printed wiring board fabrication due to anisotropic behaviour which results in severe bow and warp of the fabricated wiring board. Thus, there is a desire to develop a resin formulation which can be used to fabricate a large variety of molded electrical devices requiring VPS exposure and which maintain their dimensional integrity after VPS exposure.

In the present invention it has been found that the combination of a particular amorphous thermoplastic polymer and a particular crystalline thermoplastic polymer provides a material which is useful as an electrical/support element in electrical devices, is vapor phase solderable, and maintains its dimensional integrity.

The present invention is thus directed to a molded electrical device comprising an electrically conductive pathway and an insulating material, the device being capable of interconnection with external circuitry, said insulating material comprising a blend of a particular amorphous thermoplastic polymer and a particular crystalline thermoplastic polymer. It is also directed to corresponding molded circuit board substrates and molded chip carriers.

The composition to be used as the insulating material in the electrical device and for the production of said circuit board substrates and chip carriers comprises 35 to 65 weight percent, preferably from 40 to 60 weight percent, and most preferably 50 weight percent, of an amorphous thermoplastic polymer selected from certain polyarylethersulfones (to be defined below), and a polyetherimide, and from 65 to 35 weight percent, preferably from 40 to 60 weight percent, and most preferably 50 weight percent, of a crystalline polymer selected from a poly(arylene sulfide) and a polyester.

Preferred compositions include blends of polyarylethersulfone with poly)arylene sulfide) or polyesters or mixtures of one or more of these. Most preferred compositions include mixtures of polyarylethersulfone and polyesters, particularly poly(ethylene terephthalate) and mixtures of polyarylethersulfone and poly(arylene sulfide).

The Electrical Device

The electrical device of this invention includes chip carriers which are holders for microcircuits with contacts and wire bonding pads used to protect the microcircuit and interconnect it with a printed circuit board; printed circuit boards as an extruded injection moldable, or laminated support for additive or

substractively produced circuit elements and components; electrical connectors which are assemblies of conducting elements arranged in the insulating material employed in this invention and used for circuit element interconnection.

The chip carrier, printed circuit board and electrical connectors are made by well known methods in the art such as by injection, compression, or transfer molding or by lamination. Representative methods are described in, for example US—A—4,147,889 and 3,975,757.

The Amorphous Polymers

A. Polyarylethersulfones

The polyarylethersulfones to be employed according to this invention are amorphous thermoplastic polymers containing units of the formula:

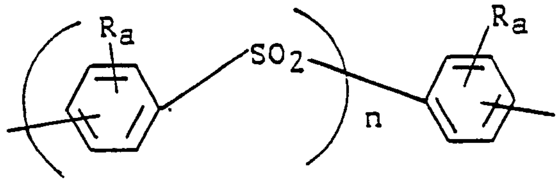 , and (I)

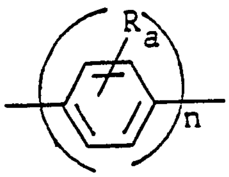 , (II)

and/or

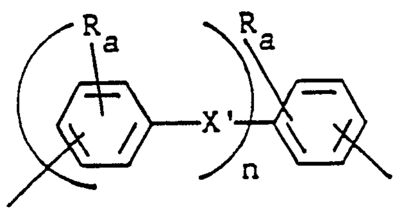 (III)

wherein R is independently hydrogen, $C_1$ to $C_6$ alkyl or $C_4$ to $C_8$ cycloalkyl, X′ is independently

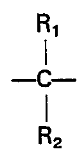

wherein $R_1$ and $R_2$ are independently hydrogen or $C_1$ to $C_9$ alkyl, or

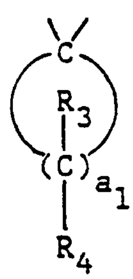

wherein $R_3$ and $R_4$ are independently hydrogen or $C_1$ to $C_8$ alkyl, and $a_1$ is an integer of 3 to 8; —S—, —O—, or

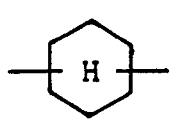 ,

a is an integer of 0 to 4 and n is independently an integer of 1 to 3 and wherein the ratio of unit (I) to the sum of units (II) and/or (III) is greater than 1. The units are attached to each other by an —O— bond.

A preferred polyarylethersulfone contains units of the formulae:

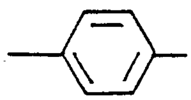 , or 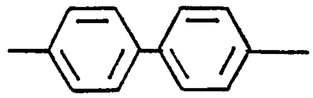

and 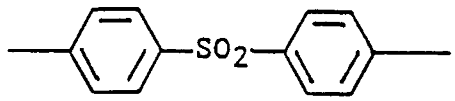

Another preferred polyarylethersulfone contains units of the formula:

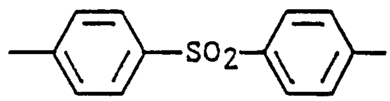 , and

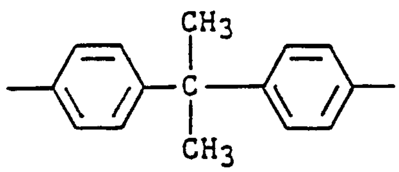

These units are attached to each other by an —O— bond.

The polyarylethersulfone may be random or may have an ordered structure.

The polyarylethersulfones have a reduced viscosity of from about 0.4 to greater than about 2.5, as measured in N-methylpyrrolidone, or other suitable solvent, at 25°C.

The polyarylethersulfones are prepared by reacting the monomers represented by the following formulae:

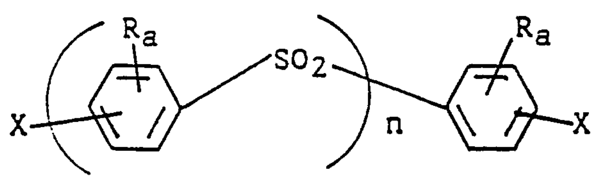 (IV)

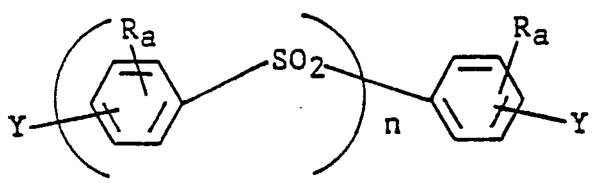 (V)

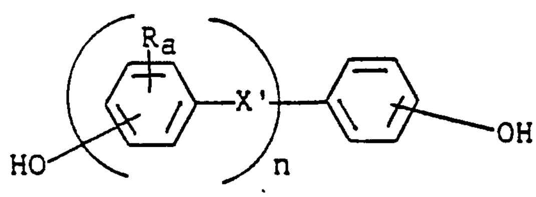 (VI)

and/or 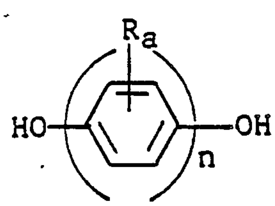 (VII)

wherein R, a, X' and n are as previously defined, and X and Y are independently selected from Cl, Br, F, $NO_2$ or OH and at least 50 percent of the Y's are OH.

The ratio of the concentration of OH groups to Cl, Br, F and/or $NO_2$ groups used to form the polyarylethersulfone is from about 0.90 to about 1.10, preferably from about 0.98 to about 1.02.

The monomers, represented by formulas (IV), (V), (VI) and (VII), include the following:
2,2-bis(4-hydroxyphenyl)propane,
bis(4-hydroxyphenyl)methane,
4,4'-dihydroxydiphenyl sulfide,
4,4'-dihydroxydiphenyl ether,
4,4'-dihydroxydiphenyl sulfone,
2,4'-dihydroxydiphenyl sulfone,
4,4-dichloroxydiphenyl sulfone,
4,4-dinitrodiphenyl sulfone,
4-chloro-4'-hydroxydiphenyl sulfone,
4,4'-biphenol and hydroquinone.

The preferred monomers include hydroquinone, 4,4-biphenol, 2,2-bis(4-hydroxyphenyl) propane, 4,4'-dichlorodiphenyl sulfone, and 4,4'-dihydroxydiphenyl sulfone or 4 chloro -4'-hydroxydiphenyl sulfone.

The polymers are prepared by contacting substantially equimolar amounts of the hydroxy containing compounds (depicted in formulas (IV) to (VII) supra) and halo and/or nitro containing compounds (depicted in formula (IV) and (V) supra) with from about 0.5 to about 1.0 mole of an alkali metal carbonates per mole of hydroxyl group in a solvent mixture comprising a solvent which forms an azeotrope with water in order to maintain the reaction medium at substantially anhydrous conditions during the polymerization.

The temperature of the reaction mixture is kept at from about 120 to about 180°C, for about 1 to about 5 hours and then raised and kept at from about 200 to about 250°C, preferably from about 210 to about 230°C, for about 1 to 10 hours.

The reaction is carried out in an inert atmosphere, e.g., nitrogen, at atmospheric pressure, although higher or lower pressures may also be used.

The polyarylethersulfone is then recovered by conventional techniques such as coagulation and solvent evaporation.

The solvent mixture comprises a solvent which forms an azeotrope with water and a polar aprotic solvent. The solvent which forms an azeotrope with water includes an aromatic hydrocarbon such as benzene, toluene, xylene, ethylbenzene and chlorobenzene.

The polar aprotic solvents are those generally known in the art for the manufacture of polyarylether sulfones and include sulfur containing solvents such as those of the formula:

$$R_5—S(O)_b—R_5$$

in which each $R_5$ represents a monovalent lower hydrocarbon group free of aliphatic unsaturation, which preferably contains less than about 8 carbon atoms or when connected together represents a divalent alkylene group with b being an integer from 1 to 2 inclusive. Thus, in all of these solvents all oxygens and two carbon atoms are bonded to the sulfur atom. Contemplated for use are such solvents as those having the formula:

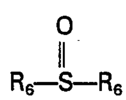 and 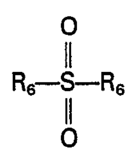

where the $R_6$ groups are independently lower alkyl, such as methyl, ethyl, propyl and butyl groups, and aryl groups such as phenyl and alkylphenyl groups such as the tolyl group, as well as those where the $R_6$ groups are interconnected as in a divalent alkylene bridge such as:

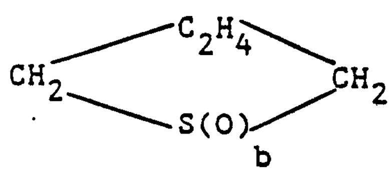

in tetrahydrothiophene oxides and dioxides. Specifically, these solvents include dimethylsulfoxide, dimethylsulfone, diphenylsulfone, diethylsulfoxide, diethylsulfone, diisopropylsulfone, tetrahydrophiophene 1,1-dioxide (commonly called tetramethylene sulfone or sulfolane) and tetrahydrothiophene-1 monoxide.

Additionally, nitrogen containing solvents may be used. These include dimethyl acetamide, dimethyl formamide and N-methylpyrrolidone.

The azeotrope-forming solvent and polar aprotic solvent are used in a weight ratio of from about 10:1 to about 1:1, preferably from about 7:1 to about 5:1.

In the reaction, the hydroxy containing compound is slowly converted, *in situ*, to the alkali salt thereof by reacting with the alkali metal carbonate. The alkali metal carbonate is preferably potassium carbonate. Mixtures of carbonates such as potassium and sodium carbonate may also be used.

Water is continuously removed from the reaction mass as an azeotrope with the azeotrope forming solvent so that substantially anhydrous conditions are maintained during the polymerization.

It is essential that the reaction medium be maintained substantially anhydrous during the polycondensation. While amounts of water up to about one percent can be tolerated, and are somewhat beneficial when employed with fluorinated dihalobenzenoid compounds, amounts of water substantially greater than this are desirably avoided as the reaction of water with the halo and/or nitro compound leads to formation of phenolic species and only low molecular weight products are secured. Consequently, in order to secure the high molecular weight polymers, the system should be substantially anhydrous, and preferably contain less than 0.5 percent by weight water during the reaction.

Preferably, after the desired molecular weight has been attained, the polymer is treated with an activated aromatic halide or an aliphatic halide such as methyl chloride or benzyl chloride. Such treatment of the polymer converts the terminal hydroxyl groups into ether groups which stabilize the polymer. The polymer so treated has good melt and oxidative stability.

B. Polyetherimides

The polyetherimides suitable for use in this invention are well known in the art and are described in, for example US—A—3,847,867, 3,838,097 and 4,107,147.

Said polyetherimides are of the following formula:

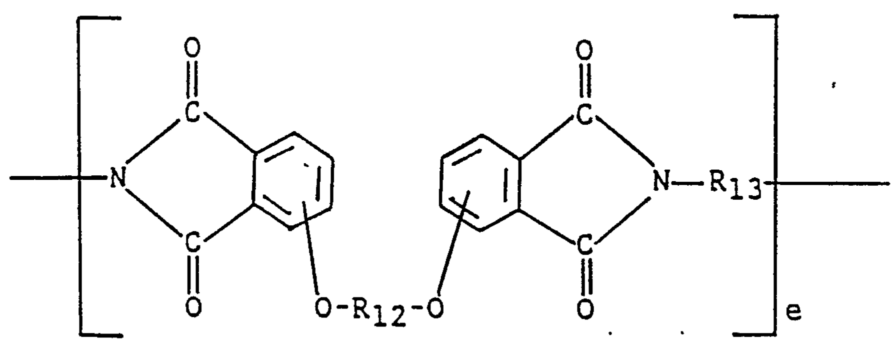

(VIII)

wherein e is an integer greater than 1, preferably from about 10 to about 10,000 or more, $—O—R_{12}—O—$ is attached to the 3 or 4 and 3′ or 4′ positions and $R_{12}$ is selected from (a) a substituted or unsubstituted aromatic radical such as

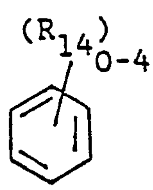

, or

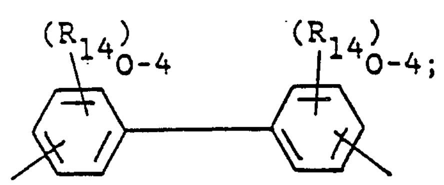

(b) a divalent radical of the formula:

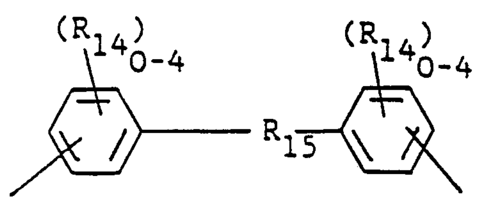

wherein $R_{14}$ is independently $C_1$ to $C_6$ alkyl, aryl or halogen and $R_{15}$ is selected from —O—, —S—,

$$—\overset{O}{\overset{\|}{C}}—,$$

$—SO_2—$, —SO—, alkylene of 1 to 6 carbon atoms, cycloalkylene of 4 to 8 carbon atoms, alkylidene of 1 to 6 carbon atoms or cycloalkylidene of 4 to 8 carbon atoms, $R_{13}$ is selected from an aromatic hydrocarbon radical having from 6 to 20 carbon atoms and halogenated derivatives thereof, or alkyl substituted derivatives thereof, wherin the alkyl group contains 1 to 6 carbon atoms, alkylene and cycloalkylene radicals having from 2 to 20 carbon atoms and $C_2$ to $C_8$ alkylene terminated polydiorganosiloxane or a divalent radical of the formula

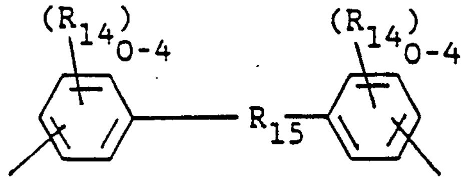

wherein $R_{14}$ and $R_{15}$ are as previously defined.

The polyetherimides may also be of the following formula:

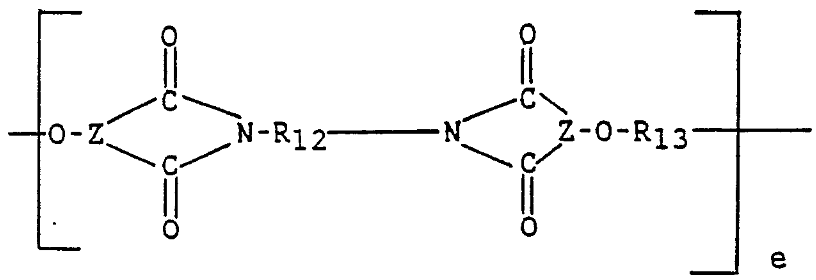

(IX)

wherein —O—Z is a member selected from

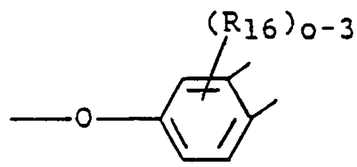

wherein $R_{16}$ is independently hydrogen, $C_{1-6}$ alkyl or $C_{1-6}$ alkoxy

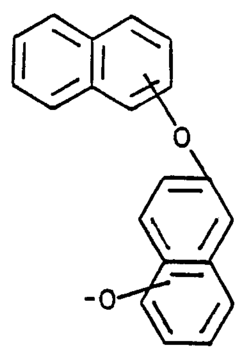

and,

wherein the oxygen may be attached to either ring and located ortho or para to one of the bonds of the imide carbonyl groups, $R_{12}$ and $R_{13}$ and e are as previously defined.

These polyetherimides are prepared by methods well known in the art as set forth in, for example, US—A—3,833,544, 3,887,588, 4,017,511, 3,965,125 and 4,024,110.

The polyetherimides of Formula (VIII) can, for example, be obtained by any of the methods well-known to those skilled in the art including the reaction of any aromatic bis(ether anhydride)s of the formula

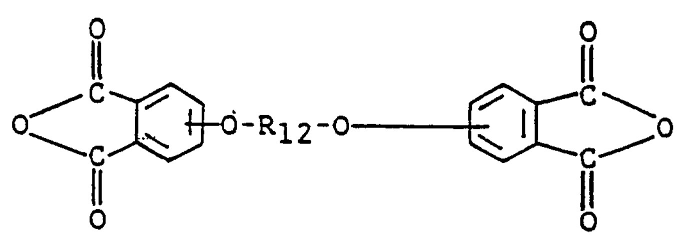

(X)

where $R_{12}$ is as defined hereinbefore, with a diamino compound of the formula

$$H_2N—R_{13}—NH_2 \quad (XI)$$

where $R_{13}$ is as defined hereinbefore. In general, the reactions can be advantageously carried out employing well-known solvents, e.g., o-dichlorobenzene, m-cresol/toluene, N,N-dimethylacetamide, etc., in which to effect interaction between the dianhydrides and diamines, at temperatures of from about 20 to

about 250°C. Alternatively, the polyetherimides can be prepared by melt polymerization of any dianhydrides of Formula (X) with any diamino compound of Formula (XI) while heating the mixture of the ingredients at evelated temperatures with concurrent intermixing. Generally, melt polymerization temperatures between about 200° to 400°C and preferably 230° to 300°C can be employed. Any order of addition of chain stoppers ordinarily employed in melt polymerizations can be employed. The conditions of the reaction and the proportions of ingredients can be varied widely depending on the desired molecular weight, intrinsic viscosity, and solvent resistance. In general, equimolar amounts of diamine and dianhydride are employed for high molecular weight polyetherimides, however, in certain instances, a slight molar excess (about 1 to 5 mole percent) of diamine can be employed resulting in the production of polyetherimides of Formula VIII having an intrinsic viscosity $\eta$ greater than 0.2 deciliters per gram, preferably 0.35 to 0.60, or 0.7 deciliters per gram or even higher when measured in m-cresol at 25°C.

The aromatic bis(ether anhydride)s of Formula (X) include, for example,
2,2-bis[4-(2,3-dicarboxyphenoxy)phenyl]-propane dianhydride;
4,4′-bis(2,3-dicarboxyphenoxy)diphenyl ether dianhydride;
1,3-bis(2,3-dicarboxyphenoxy)benzene dianhydride;
4,4′-bis(2,3-dicarboxyphenoxy)diphenyl sulfide dianhydride;
1,4-bis(2,3-dicarboxyphenoxy)benzene dianhydride;
4,4′-bis(2,3-dicarboxyphenoxy)benzophenone dianhydride;
4,4′-bis(2,3-dicarboxyphenoxy)diphenyl sulfone dianhydride;
2,2-bis[4-(3,4-dicarboxyphenoxy)phenyl]propane dianhydride;
4,4′-bis(3,4-dicarboxyphenoxy)diphenyl ether dianhydride;
4,4′-bis(3,4-dicarboxyphenoxy)diphenyl sulfide dianhydride;
1,3-bis(3,4-dicarboxyphenoxy)benzene dianhydride;
1,4-bis(3,4-dicarboxyphenoxy)benzene dianhydride;
4,4′-bis(3,4-dicarboxyphenoxy)benzophenone dianhydride;
4-(2,3-dicarboxyphenoxy)-4′-(3,4-dicarboxyphenoxy)diphenyl-2,2-propane dianhydride; etc. and mixtures of such dianhydrides.

The organic diamines of Formula (XI) include, for example, m-phenylenediamine, p-phenylenediamine, 2,2-bis(p-aminophenyl)propane, 4,4′-diaminodiphenyl-methane, 4,4′-diaminodiphenyl sulfide, 4,4′-diamino-diphenyl sulfone, 4,4′-diaminodiphenyl ether, 1,5-diaminonaphthalene, 3,3′-dimethylbenzidine, 3,3′-dimethoxybenzidine.

The polyetherimides of formula (VIII) may, for example, be prepared by effecting reaction in the presence of a dipolar aprotic solvent of a mixture of ingredients comprising, for instance, (1) a bis(nitrophthalimide) of the general formula:

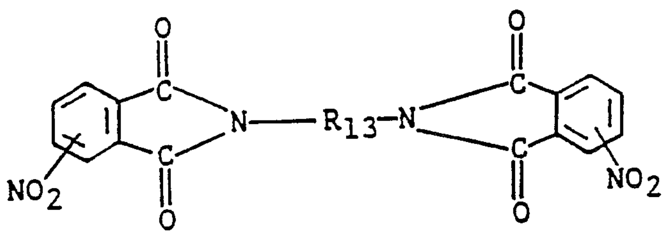

(XII)

wherein $R_{13}$ is defined as hereinabove, and (2) an alkali metal salt of an organic compound of the general formula:

$$MO—R_{12}—OM \qquad (XIII)$$

wherein M is an alkali metal and $R_{12}$ is defined as hereinabove.

The bis(nitrophthalamide) used in preparing the polymer is formed by reacting a diamine of the formula described above, $NH_2R_{13}—NH_2$, with a nitro-substituted aromatic anhydride of the formula:

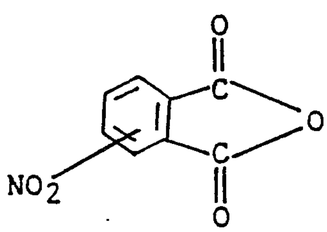

(XIV)

The molar ratio of diamine to anhydride should ideally be about 1:2 respectively. The initial reaction product is a bis(amide-acid) which is subsequently dehydrated to the corresponding bis(nitrophthalimide).

The diamines are described, *supra.*

The preferrred nitrophthalic anhydrides useful in the present invention are 3-nitrophthalic anhydride, 4-nitrophthalic anhydride, and mixtures thereof. These reactants are commercially available in reagent

grade. They may also be prepared by the nitration of phthalic anhydride using procedures described in Organic Syntheses, Collective Vol. I, Wiley (1948), page 408. Certain other closely related nitroaromatic anhydrides may also be used in the reaction and are illustrated for example by 2-nitronaphthalic anhydride, 1-nitro-2,3-naphthalenedicarboxylic anhydride and 3-methoxy-6-nitrophthalic anhydride.

With reference to the alkali metal salts of formula (XIII) among the divalent carbocyclic aromatic radicals which $R_{12}$ may represent (mixtures of such radicals are also included) are, for instance, divalent aromatic hydrocarbon radicals of from 6 to 20 carbon atoms, such as phenylene, biphenylene, naphthylene. Included are residues of, e.g. hydroquinone, resorcinol, chlorohydroquinone. In addition, $R_{12}$ may be a residue of a dihydroxyl diarylene compound in which the aryl nuclei are joined by either an aliphatic group, a sulfoxide group, sulfonyl group, sulfur, carbonyl group or oxygen. Typical of such diarylene compounds are the following:

2,4-dihydroxydiphenylmethane;
bis(2-hydroxyphenyl)methane;
2,2-bis(4-hydroxyphenyl)propane;
bis(4-hydroxyphenyl)methane;
bis(4-hydroxy-5-nitrophenyl)methane;
bis(4-hydroxy-2,6-dimethyl-3-methoxyphenyl)methane;
1,1-bis(4-hydroxyphenyl)ethane;
1,2-bis(4-hydroxyphenyl)ethane;
1,1-bis(4-hydroxy-2-chlorophenyl)ethane;
1,1-bis(2,5-dimethyl-4-hydroxyphenyl)ethane;
1,3-bis(3-methyl-4-hydroxyphenyl)propane;
2,2-bis(3-phenyl-4-hydroxyphenyl)propane;
2,2-bis(3-isopropyl-4-hydroxyphenyl)propane;
2,2-bis(4-hydroxynaphthyl)propane;
hydroquinone;
naphthalene diols;
bis(4-hydroxyphenyl)ether;
bis(4-hjydroxyphenyl)sulfide;
bis(4-hydroxyphenyl)sulfone.

When dialkali metal salts of formula (XIII) are used with the compound illustrated by formula (XII), the ingredients are advantageously present in an equal molar ratio for optimum molecular weight and properties of the polymer. Slight molar excesses, e.g., about 0.001 to 0.10 molar excess of either the dinitro-substituted organic compound or of the dialkali metal salt of formula (XIII) may be employed. When the molar ratios are approximately equal to polymer is substantially terminated by a $=Z—NO_2$ at one end and a phenolic group at the other end. If there is a molar excess of one compound, that particular terminal group will predominate.

The conditions of reaction whereby the alkali-metal salt of formula (XIII) is reacted with the dinitro-substituted organic compound of formula (XII) can be varied widely. Generally, temperatures of the order of about 25 to about 150°C are advantageously employed, although it is possible to employ lower or higher temperature conditions depending on the ingredients used, the reaction product sought, time of reaction and solvent employed. In addition to atmospheric pressure, superatmospheric pressures and subatmospheric pressures may be employed depending upon the other conditions of reaction, the ingredients used, the speed at which it is desired to effect reaction.

The time of reaction also can be varied widely depending on the ingredients used, the temperature, the desired yield. It has been found that times varying from about 5 minutes to as much as 30 to 40 hours are advantageously employed to obtain the maximum yield and desired molecular weight. Thereafter the reaction product can be treated in the appropriate manner required to effect precipitation and/or separation of the desired polymeric reaction product. Generally, common solvents such as alcohols (e.g. methanol, ethanol, isopropyl alcohol) and aliphatic hydrocarbons (e.g. pentane, hexane, octane, cyclohexane) may be employed as precipitants for this purpose.

It is important that the reaction between the dinitro-substituted organic compound of formula XII and the alkali-metal salt of formula XIII (mixtures of such alkali-metal salts can also be used) be carried out in the presence of a dipolar aprotic solvent.

The polymerization is performed under anhydrous conditions usually using dipolar aprotic solvents such as dimethylsulfoxide which are added in varying amounts depending upon the particular polymerization. A total quantity of solvent, dipolar aprotic solvent or mixture of such solvent with an aromatic solvent sufficient to give a final solution containing 10 to 20% by weight of polymer is preferably employed.

The preferred polyetherimides include those having repeating units of the following formula:

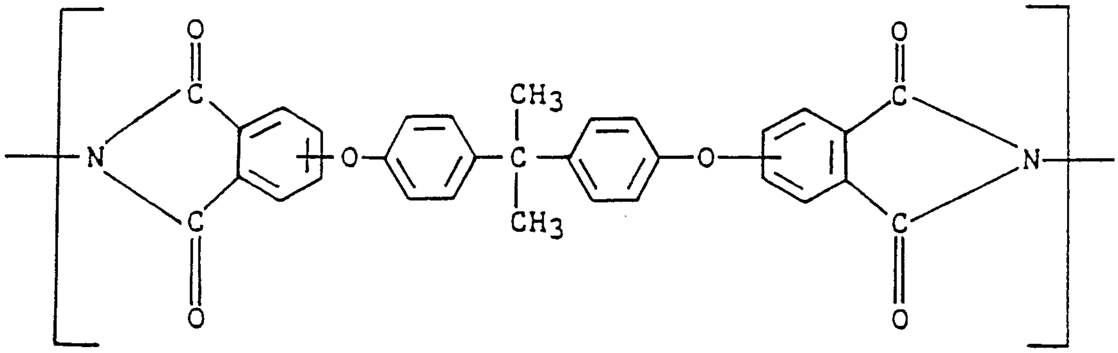

The Crystalline Polymers

A. Polyesters

The polyesters which are suitable for use herein are derived from an aliphatic or cycloaliphatic diol, or mixtures thereof, containing from 2 to about 10 carbon atoms and at least one aromatic dicarboxylic acid. The polyesters which are derived from an aliphatic diol and an aromatic dicarboxylic acid have repeating units of the following general formula:

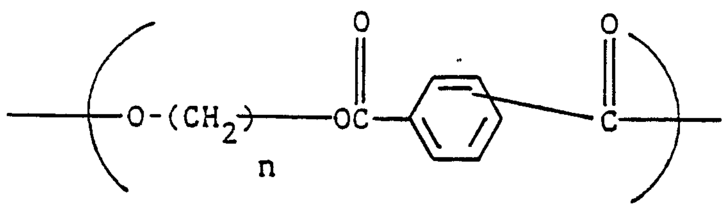

XV

wherein n is an integer of from 2 to 10.

Preferred polyesters include poly(ethylene terephthalate) and poly(butylene terephthalate).

Also contemplated herein are the above polyesters with minor amounts, e.g., from 0.5 to about 2 percent by weight, of units derived from aliphatic acids and/or aliphatic polyols, to form copolyesters. The aliphatic polyols include glycols, such as poly(ethylene glycol). These can be made following the teachings of, for example, US—A—2,465,319 and 3,047,539.

The polyesters which are derived from a cycloaliphatic diol and an aromatic dicarboxylic acid are prepared by condensing either the cis — or trans-isomer (or mixtures thereof) of, for example, 1,4-cyclohexanedimethanol with an aromatic dicarboxylic acid so as to produce a polyester having recurring units of the following formula:

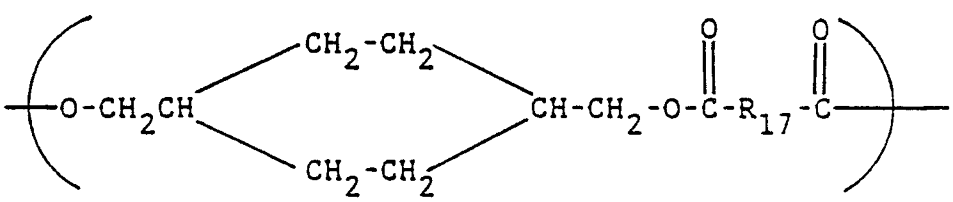

(XVI)

wherein the cyclohexane ring is selected from the cis- and trans- isomers thereof and $R_{17}$ represents an aryl radical containing 6 to 20 carbon atoms and which is the decarboxylated residue derived from an aromatic dicarboxylic acid.

Examples of aromatic dicarboxylic acids indicated by $R_{17}$ in formula XVI, are isophthalic or terephthalic acid, 1,2-di(p-carboxyphenyl)ethane, 4,4'-dicarboxydiphenyl ether, and mixtures of these. All of these acids contain at least one aromatic nucleus. Fused rings can also be present, such as in 1,4- or 1,5-naphthalenedicarboxylic acids. The preferred dicarboxylic acids are terephthalic acid or a mixture of terephthalic and isophthalic acids.

A preferred polyester may be derived from the reaction of either the cis- or trans-isomer (or a mixture thereof) of 1,4-cyclohexanedimethanol with a mixture of isophthalic and terephthalic acids. These polyesters have repeating units of the formula:

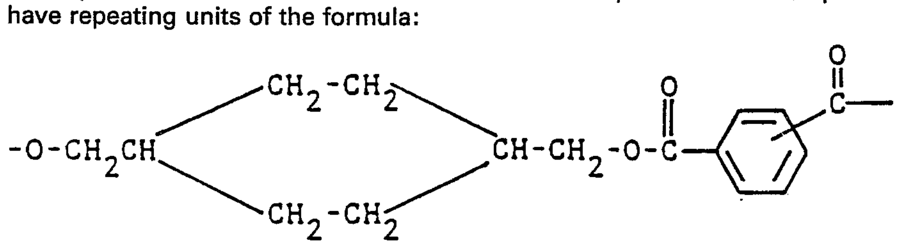

(XVII)

Another preferred polyester is a copolyester derived from a cyclohexane dimethanol, an alkylene glycol and an aromatic dicarboxylic acid. These copolyesters are prepared by condensing either the cis- or trans-isomer (or mixtures thereof) of, for exmaple, 1,4-cyclohexanedimethanol and an alkylene glycol with an aromatic dicarboxylic acid so as to produce a copolyester having repeating units of the following formula:

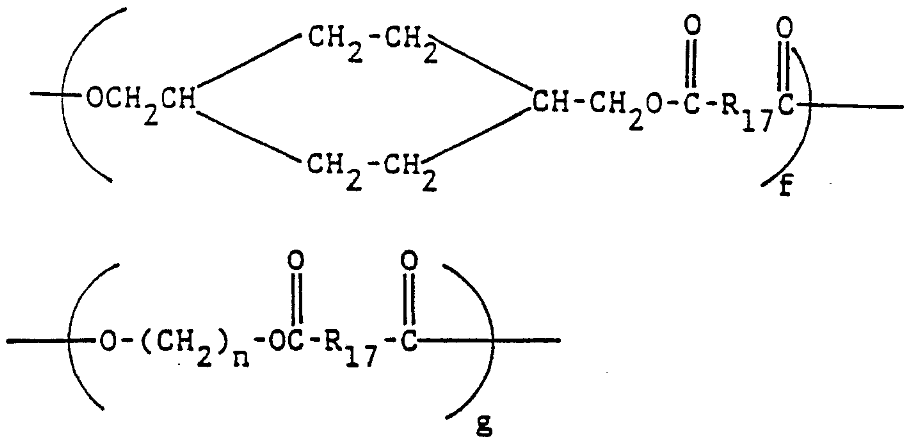 (XVIII)

wherein the cyclohexane ring is selected from the cis- and trans- isomers thereof, $R_{17}$ is as previously defined, n is an integer of 2 to 10, the f units comprise from about 10 to about 90 percent by weight and the g units comprise from about 10 to about 90 percent by weight.

The preferred copolyesters may be derived from the reaction of either the cis- or trans-isomer (or mixtures thereof) of 1,4-cyclohexanedimethanol and ethylene glycol with terephthalic acid in a molar ratio of 1:2:3. These copolyesters have repeating units of the following formula:

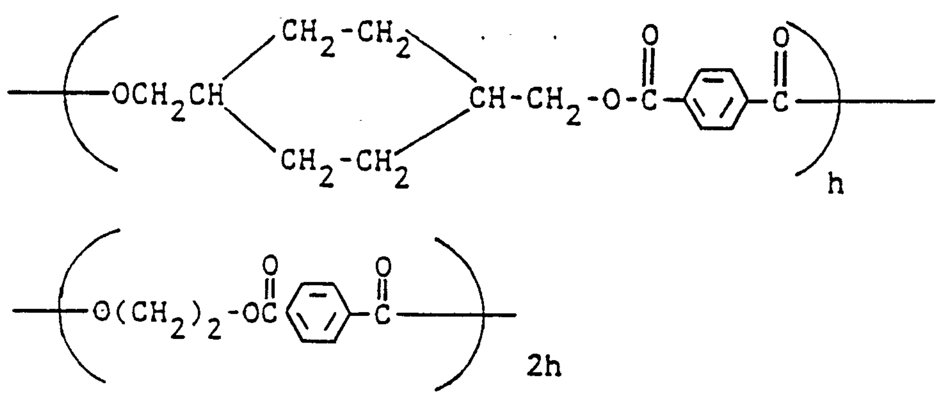 (XIX)

wherein h can be 10 to 10,000. Block as well as random copolymers are possible.

The polyester as described herein are either commercially available or can be produced by methods well known in the art, such as those set forth in, for example, US—A—2,901,466.

The polyesters used herein have an intrinsic viscosity of from about 0.4 to about 2.0 dl/g, as measured in a 60:40 phenol/tetrachloroethane mixture or similar solvent at 23 to 30°C.

B. Poly(arylene sulfide)

The poly(arylene sulfide)s which are suitable for use herein are solid, have a melting point of at least about 66°C (150°F) and are insoluble in common solvents. Such resins can be conveniently prepared by the process disclosed in, for example, US—A—3,354,129. Briefly, the process comprises the reaction of an alkali metal sulfide and a polyhalo ring-substituted aromatic compound in the presence of a suitable polar organic compound, as for example, the reaction of sodium sulfide with dichlorobenzene in the presence of N-methyl-2-pyrrolidone to form poly(phenylenesulfide).

The resulting polymer contains the aromatic nucleus of the polyhalo-substituted monomer coupled in repeating units predominantly through a sulfur atom. The polymers which are preferred for use according to this invention are those polymers having the repeating unit —$R_{23}$—S— where $R_{23}$ is phenylene, biphenylene, naphthylene, or a lower alkyl-substituted derivative thereof. By lower alkyl is meant alkyl groups having one to six carbon atoms such as methyl, propyl, isobutyl and n-hexyl.

The preferred poly(arylene sulfide) is poly(phenylene sulfide), a crystalline polymer with a repeating structural unit comprising a para-substituted bezene ring and a sulfur atom which may be described by the following formula, where p and a value of at least about 50.

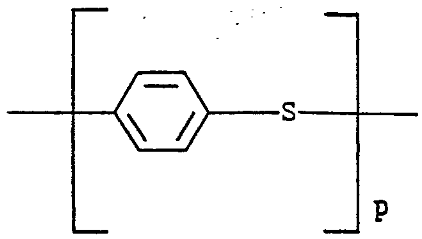

Suitable poly(phenylene sulfide) compositions are available commercially under the trade name Ryton of the Phillips Petroleum Company. Preferably, the poly(phenylene sulfide) component has a melt flow index, measured at 316°C (600°F) using a 5 kg weight and a standard orifice, within the range of from about 10 to about 7000 dg./min.

The term poly(arylene sulfide) is meant to include not only homopolymers but also arylene sulfide copolymers and terpolymers.

Other Additives

Other additives which may be used in combination with the thermoplastic polymers include mineral fillers such as carbonates including chalk, calcium carbonate, calcite and dolomite; silicates including mica, talc, wollastonite; silicon dioxide; glass spheres; glass powders aluminum; clay; and quartz. Additional additives include reinforcements such as glass fibers, carbon fibers, polyamides, silicon carbide, pigments, such as titanium dioxide; thermal stabilizers such as zinc oxide; ultraviolet light stabilizers and plasticizers.

The mineral fillers and reinforcements may be used in amounts of up to about 40, preferably up to about 30 weight percent. The pigments are generally used in amounts of up to about 10 weight percent. The stabilizers are used in stabilizing amounts to stabilize the composition for the effect desired.

Additionally, nucleation additives such as sodium benzoate, various fillers and Cab-o-sil ®, can be added to improve the crystallization rate so that injection molded articles will attain higher levels of crystallinity.

Examples

The following examples serve to give specific illustrations of the practice of this invention.

The following designations used in the Examples have the following meaning:

*Polyarylethersulfone*: A polymer having the following repeating unit:

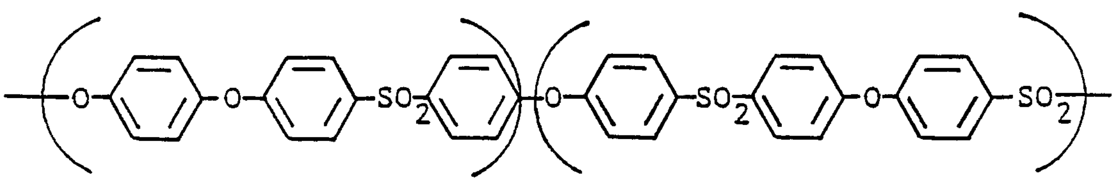

The polymer has a reduced viscosity of 0.61 dl/g as measured in N-methyl-pyrrolidinone (0.2 g/100 ml) at 25°C.

*Polysulfone*: A polymer having the following repeating unit:

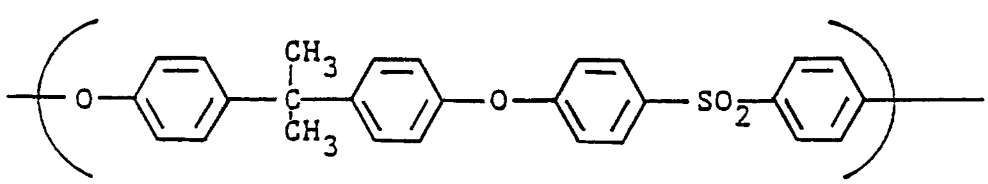

This polymer has a reduced viscosity of 0.47 dl/g as measured in chloroform (0.1 g/100 ml) at 25°C.

*Polyetherimide*: A polymer having a repeat unit of the formula:

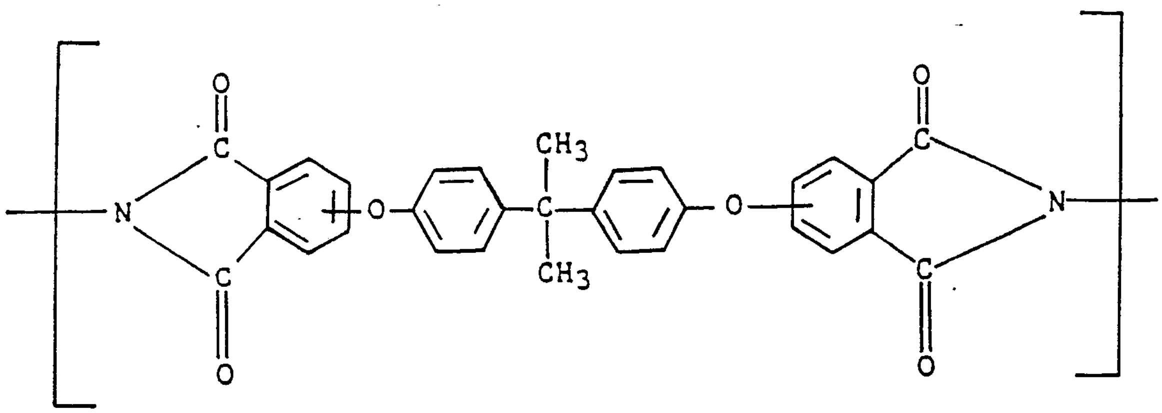

This polymer has a reduced viscosity of 0.51 as measured in chloroform (0.5 g. per 100 ml) at 25°C.

Controls A and B

Polyarylethersulfone and Polysulfone were injection molded into 3.175 mm (1/8 inch) thick tensile specimens on an Arburg reciprocating screw injecting molding machine at about 382°C (720°F), immersed in water for 16 hours, and completely submerged in molten solder at 216°C (420°F) for 60—120 seconds (simulation of VPS exposure). The latter represents a rigorous thermal exposure which resulted in bubbling, foaming, and distortion of the test specimens.

The test specimens were measured for the following properties: tensile modulus, tensile strength and percent elongation according to ASTM D—638, tensile impact according to ASTM D—1822; flexural strength and modulus according to ASTM D—638 and heat distortion temperature (HDT) according to ASTM D—648.

TABLE I

| Test Property | Polyaryl-ethersulfone | Poly-sulfone |
|---|---|---|
| Tensile Strength MPa (psi) | 82.7 (12,000) | 70.3 (10,200) |
| Tensile Modulus MPa (psi) | 2653 (385,000) | 2480 (360,000) |
| % Elongation at Break | 40 | 50—100 |
| Flexural Strength MPa (psi) | 111 (16,100) | 106 (15,400) |
| Flexural Modulus MPa (psi) | 2749 (399,000) | 2687 (390,000) |
| HDT at 1.82 MPa (264 psi) | 204°C | 174°C |

Example 1

35 parts by weight of Polyarylethersulfone, 35 parts by weight of poly(ethylene terephthalate) (Cleartuf® 7202A, obtained from Goodyear Tire and Rubber Co.), 20 parts by weight of fiberglass (OCF—497B, Owens-Corning Corp., Anderson, SC) and 10 parts by weight of talc (reagent grade, Mallinckrodt, Inc., Paris, KY) were blended in a single screw 2.5 cm (one-inch) diameter extruder (L/D = 20) equipped with a Maddox® mixing head at about 275°C and molded into ASTM specimens. The specimens were tested as in Controls A and B.

Example 2

A poly(phenylene sulfide) resin (Ryton® P—4 obtained from Phillips Chemical Co., Houston, TX) was placed in a pan to a depth of 5.1 cm (2 inches). The pan was then placed in a circulating air oven at 240°C for 17 hours to advance it. After advancing the resin had a melt flow of 1.4 dg/min as measured according to ASTM D—1238 at 300°C, 303 kPa (44 psi). Thirty-five parts by weight of the poly(phenylene sulfide) was blended with 35 parts by weight of Polyarylethersulfone, 28 parts by weight of muscovite mica (English Mica Co., Stamford, CT) and 2 parts by weight zinc oxide in a single screw 2.5 cm (one-inch) diameter extruder (L/D = 20) equipped with a Maddox® mixing head at about 310°C into ASTM specimens. The specimens were tested as in Controls A and B.

Example 3

Thirty-five parts by weight of the advanced poly(phenylene sulfide) resin of Example 2 was blended with 35 parts by weight of Polyarylethersulfone, 28 parts by weight of fiberglass (Owens-Corning

OCF—497B) and 2 parts by weight zinc oxide in a single scew 2.5 cm (one-inch) diameter extruder (L/D = 20) equipped with a Maddox® mixing head at about 310°C into ASTM specimens. The specimens were tested as in Controls A and B.

TABLE II
Formulations of Examples 1 to 3

| Ingredients | Examples 1 | 2 | 3 |
|---|---|---|---|
| Poly(phenylene sulfide) | — | 35% | 35% |
| Polyarylethersulfone | 35% | 35% | 35% |
| Poly(ethylene terephthalate) | 35% | — | — |
| Fiberglass | 20% | — | 28% |
| Talc | 10% | — | — |
| Zinc Oxide | — | 2% | 2% |
| Mica | — | 28% | — |

Table III depicts the physical properties of the resins of Examples 1 to 3.

TABLE III
Examples

| | 1 | | 2 | | 3 | |
|---|---|---|---|---|---|---|
| Tensile Strength MPa (psi) | 90.9 | (13,200) | 73.0 | (10,600) | 110 | (15,900) |
| Tensile Modulus MPa (psi) | 7166 | (1,040,000) | 10,610 | (1,540,000) | 11369 | (1,650,000) |
| % Elongation to Break | | 1.54 | | 0.89 | | 1.30 |
| Flexural Strength MPa (psi) | 131 | (19,000) | 115 | (16,700) | 169 | (24,500) |
| Flexural Modulus MPa (psi) | 7648 | (1,110,000) | 9233 | (1,340,000) | 9853 | (1,430,000) |
| HDT at 1.82 MPa (264 psi) | | 205°C | | 200°C | | 209°C |

SOLDER TEST

The formulations from Table II were injection molded into 3.18 mm (1/8 inch) thick ASTM type I tensile bars on an Arburg reciprocating screw injection molding machine. The tensile specimens were immersed in water at about 25°C for 16 hours and then directly immersed in molten solder at 216°C (420°F) for 60, 90, and 120 seconds to simulate typical VPS exposure conditions. No distortion, bubbling, or foaming was observed.

Example 4

Fifty parts by weight of Polyetherimide, 30 parts by weight of the advanced poly(phenylene sulfide) resin of Example 2 and 20 parts by weight of the fiberglass of Example 3 were blended as described in Example 3 and injection molded and tested as described in the SOLDER TEST.

No distortion, bubbling, or foaming of the test specimens was observed.

Control C

Eighty parts by weight of Polyetherimide and 20 parts by weight of the fiberglass of Example 3 were blended as described in Example 3 and injection molded and tested as described in the SOLDER TEST.

The specimens showed foaming.

**Claims**

1. Molded electrical device comprising an electrically conductive pathway and an insulating material, the device being capable of interconnecting with external circuitry, said insulating material comprising from 35 to 65 weight percent of an amorphous polyarylethersulfone or an amorphous polyetherimide and

from 65 to 35 weight percent of a crystalline polymer selected from a poly(arylene sulfide) or a polyester, said polyarylethersulfone containing units of the formulae:

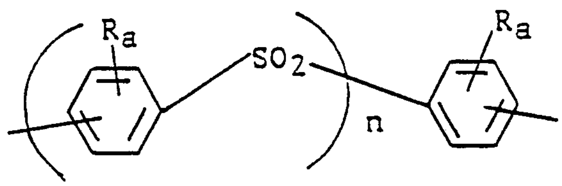

, and (I)

and/or

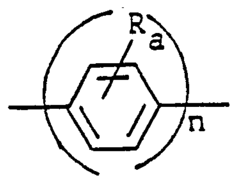

(II)

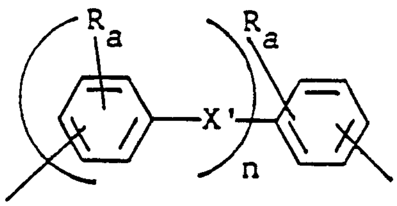

(III)

wherein R is independently hydrogen, $C_1$ to $C_6$ alkyl or $C_4$ to $C_8$ cycloalkyl, X' is independently

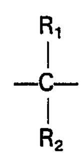

wherein $R_1$ and $R_2$ are independently hydrogen or $C_1$ to $C_9$ alkyl, or

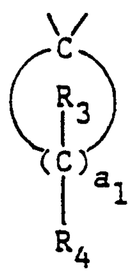

wherein $R_3$ and $R_4$ are independently hydrogen or $C_1$ to $C_8$ alkyl, and $a_1$ is an integer of 3 to 8; —S—, —O—, or

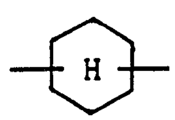

,

a is an integer of 0 to 4 and n is independently an integer of 1 to 3 and wherein the ratio of unit (I) to the sum of units (II) and/or (III) is greater than 1; said units being attached to each other by an —O— bond.

2. Device as in claim 1 wherein the insulating material comprises from 35 to 65 weight percent of the polyarylethersulfone and from 65 to 35 weight percent of a poly(arylene sulfide).

3. Device as defined in claim 2 wherein the poly(arylene sulfide) is poly(phenylene) sulfide.

4. Device as defined in claim 1 wherein the insulating material comprises from 35 to 65 weight percent of the polyarylethersulfone and from 65 to 35 weight percent of a polyester.

5. Molded circuit board substrate made from a composition comprising from 35 to 65 weight percent of an amorphous polyarylethersulfone as defined in claim 1 or an amorphous polyetherimide and from 65 to 35 weight percent of a crystalline polymer selected from a poly(arylene sulfide) or a polyester.

6. Substrate as defined in claim 5, made from a composition comprising from 35 to 65 weight percent of the polyarylethersulfone and from 65 to 35 weight percent of a poly(arylenesulfide).

7. Substrate as defined in claim 6 wherein the poly(arylene sulfide) is poly(phenylene sulfide).

8. Substrate as defined in claim 5, made from a composition comprising from 35 to 65 weight percent

of the polyarylethersulfone and from 65 to 35 weight percent of a polyester.

9. Substrate as defined in one or more of the claims 5 to 8, which carries an electrically conductive pathway.

10. Molded chip carrier made from a composition comprising from 35 to 65 weight percent of an amorphous polymer selected from a polyarylethersulfone as defined in claim 1 or a polyetherimide and from 65 to 35 weight percent of a crystalline polymer selected from a poly(arylene sulfide) or a polyester.

11. Chip carrier as defined in claim 10, made from a composition comprising from 35 to 65 weight percent of the polyarylethersulfone and from 65 to 35 weight percent of a poly(arylene sulfide).

12. Chip carrier as defined in claim 11 wherein the poly(arylene sulfide) is poly(phenylene sulfide).

13. Chip carrier as defined in claim 10 made from a composition comrpising from 35 to 65 weight percent of the polyarylethersulfone and from 65 to 35 weight percent of a polyester.

**Patentansprüche**

1. Geformtes elektrisches Gerät, das einen elektrischen Leitungsweg und ein Isolierungsmaterial umfaßt, wobei das Gerät mit einem äußeren Schaltkreis verbunden werden kann und das Isolierungsmaterial 35 bis 65 Gew.-% eines amorphen Polyarylethersulfons oder eines amorphen Polyetherimids und 65 bis 35 Gew.-% eines kristallinen Polymers, ausgewählt aus einem Poly(arylensulfid) oder einem Polyester, umfaßt, wobei das Polyarylethersulfon Einheiten der Formeln

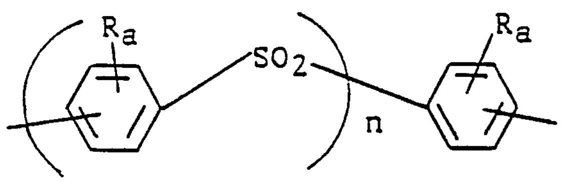

, und (I)

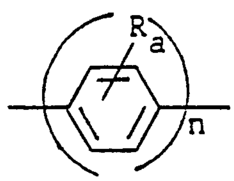

, (II)

und/oder

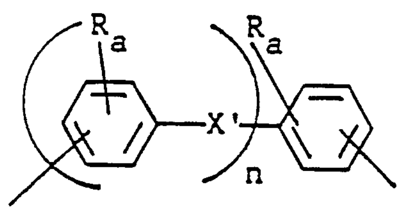

(III)

enthält, wobei R unabhängig Wasserstoff, $C_1$—$C_6$-Alkyl oder $C_4$—$C_8$-Cycloalkyl ist, X' unabhängig

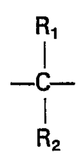

ist, worin $R_1$ und $R_2$ unabhängig Wasserstoff oder $C_1$—$C_9$-Alkyl oder

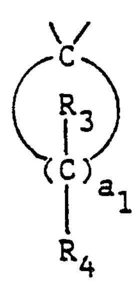

bedeuten, worin $R_3$ und $R_4$ unabhängig Wasserstoff oder $C_1$—$C_8$-Alkyl bedeuten und $a_1$ eine ganze Zahl von 3 bis 8, —S—, —O— oder

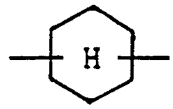 ,

ist,
a eine ganze Zahl von 0 bis 4 ist,
und n unabhängig eine ganze Zahl von 1 bis 3 ist und worin das Verhältnis von Einheit (I) zur Summe der Einheiten (II) und/oder (III) größer als 1 ist, wobei die Einheiten durch eine —O— Bindung aneinander gebunden sind.

2. Gerät nach Anspruch 1, worin das Isolierungsmaterial 35 bis 65 Gew.-% des Polyarylethersulfons und 65 bis 35 Gew.-% eines Poly(arylensulfids) umfaßt.

3. Gerät nach Anspruch 2, worin das Poly(arylensulfid) Poly(phenylen)sulfid ist.

4. Gerät nach Anspruch 1, worin das Isolierungsmaterial 35 bis 65 Gew.-% des Polyarylethersulfons und 65 bis 35 Gew.-% eines Polyesters umfaßt.

5. Geformtes Substrat für Schaltkreisplatten, hergestellt aus einer Zusamensetzung, die 35 bis 65 Gew.-% eines amorphen Polyarylethersulfons gemäß Definition in Anspruch 1 oder eines amorphen Polyetherimids und 65 bis 35 Gew.-% eines kristallinen Polymers, ausgewählt aus einem Poly(arylensulfid) oder einem Polyester, umfaßt.

6. Substrat nach Anspruch 5, hergestellt aus einer Zusammensetzung, die 35 bis 65 Gew.-% des Polyarylethersulfons und 65 bis 35 Gew.-% eines Poly(arylensulfids) umfaßt.

7. Substrat nach Anspruch 6, worin das Poly(arylensulfid) Poly(phenylensulfid) ist.

8. Substrat nach Anspruch 5, hergestellt aus einer Zusammensetzung, die 35 bis 65 Gew.-% des Polyarylethersulfons und 65 bis 35 Gew.-% eines Polyesters umfaßt.

9. Substrat nach einem oder mehreren der Ansprüche 5 bis 8, das einen elektrischen Leitungsweg trägt.

10. Geformter Chipträger, hergestellt aus einer Zusammensetzung, die 35 bis 65 Gew.-% eines amorphen Polymers, ausgewählt aus einem Polyarylethersulfon gemäß Definition in Anspruch 1 oder einem Polyetherimid, und 65 bis 35 Gew.-% eines kristallinen Polymers, ausgewählt aus einem Poly(arylensulfid), oder eines Polyesters, umfaßt.

11. Chipträger nach Anspruch 10, hergestellt aus einer Zusammensetzung, die 35 bis 65 Gew.-% des Polyarylethersulfons und 65 bis 35 Gew.-% eines Poly(arylensulfids) umfaßt.

12. Chipträger nach Anspruch 11, worin das Poly(arylensulfid) Poly(phenylensulfid) ist.

13. Chipträger nach Anspruch 10, hergestellt aus einer Zusammensetzung, die 35 bis 65 Gew.-% des Polyarylethersulfons und 65 bis 35 Gew.-% eines Polyesters umfaßt.

**Revendications**

1. Dispositif électrique moulé comprenant un trajet électriquement conducteur et un matériau isolant, le dispositif étant capable d'une interconnexion avec un circuit externe, ledit matériau isolant comprenant de 35 à 65% en poids d'une polyaryléthersulfone ou d'un polyétherimide amorphe et de 65 à 35% en poids d'un polymère cristallin choisi parmi un poly(sulfure d'arylène) ou un polyester, ladite polyaryléthersulfone contenant des motifs répondant aux formules

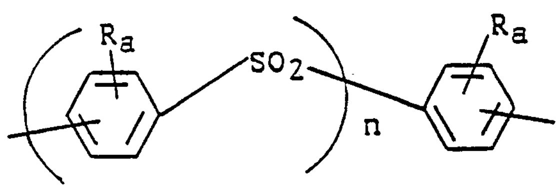 , et (I)

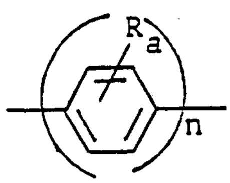 (II)

et/ou

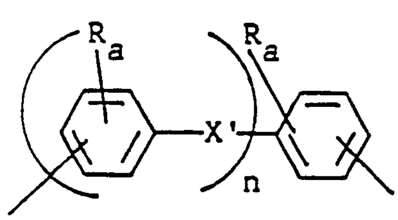 (III)

où R représente, indépendamment, un atome d'hydrogène, un groupe alkyle en $C_1$ à $C_6$ ou un groupe cycloalkyle en $C_4$ à $C_8$; X' représente indépendamment

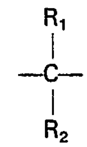

où $R_1$ et $R_2$ représentent, indépendamment l'une de l'autre, un atome d'hydrogène ou un groupe alkyle en $C_8$ à $C_9$, ou

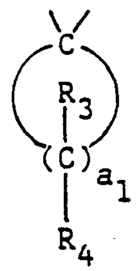

où $R_3$ et $R_4$ représentent, indépendamment l'un de l'autre, un atome d'hydrogène ou un groupe alkyle en $C_1$ à $C_8$, et $a_1$ est un nombre entier valant 3 à 8; —S—, —O— ou

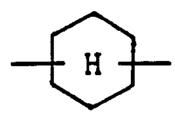 ,

a est un nombre entier valant de 0 à 4, et n est, indépendamment, un nombre entier valant de 1 à 3, et le rapport du motif (I) à la somme des motifs (II) et/ou (III) est supérieur à 1, lesdits motifs étant fixés l'un à l'autre par un chaînon —O— de liaison.

2. Dispositif selon la revendication 1, dans lequel le matériau isolant comprend de 35 à 65% en poids de polyaryléthersulfone et de 65 à 35% en poids d'un poly(sulfure d'arylène).

3. Dispositif selon la revendication 2, dans lequel le poly(sulfure d'arylène) est du poly(sulfure de phénylène).

4. Dispositif selon la revendication 1, dans lequel le matériau isolant comprend de 35 à 65% en poids de polyaryléthersulfone et de 65 à 35% en poids d'un polyester.

5. Substrat moulé pour circuit, constitué d'une composition comprenant de 35 à 65% en poids d'une polyaryléthersulfone amorphe telle que définie à la revendication 1, ou un polyétherimide amorphe, et de 65 à 35% en poids d'un polymère cristallin choisi parmi un poly(sulfure d'arylène) ou un polyester.

6. Substrat, tel que défini à la revendication 5, réalisé en une composition comprenant de 35 à 65% en poids de la polyaryléthersulfone et de 65 à 35% en poids d'un poly(sulfure d'arylène).

7. Substrat, tel que défini à la revendication 6, dans lequel le poly(sulfure d'arylène) est du poly(sulfure de phénylène).

8. Substrat, tel que défini à la revendication 5, réalisé en une composition comprenant de 35 à 65% en poids de la polyaryléthersulfone et de 65 à 35% en poids d'un polyester.

9. Substrat, tel que défini dans une ou plusieurs revendications 5 à 8, qui porte un trajet électriquement conducteur.

10. Support moulé pour "puce", réalisé en une composition comprenant de 35 à 65% en poids d'un polymère amorphe choisi parmi une polyaryléthersulfone telle que définie à la revendication 1 ou un polyétherimide et de 65 à 35% en poids d'un polymère cristallin choisi parmi un poly(sulfure d'arylène) ou un polyester.

11. Support de "puce", tel que défini à la revendication 10, réalisé en une composition comprenant de 35 à 65% en poids de la polyaryléthersulfone et de 65 à 35% en poids d'un poly(sulfure d'arylène).

12. Support de "puce", tel que défini à la revendication 11, dans lequel le poly(sulfure d'arylène) est du poly(sulfure de phénylène).

13. Support de "puce", tel que défini à la revendication 10, réalisé en une composition comprenant de 35 à 65% en poids de la polyaryléthersulfone et de 65 à 35% en poids d'un polyester.